# EUROPÄISCHE PATENTSCHRIFT

(11) **EP 2 273 278 B1**
(45) Veröffentlichungstag und Bekanntmachung des Hinweises auf die Patenterteilung: **05.09.2018**
(21) Anmeldenummer: 10006976.4
(22) Anmeldetag: 06.07.2010
(51) Int. Cl.: G01R 31/02

(54) **Prüfsystem zum Prüfen einer Leitungsanordnung und Verfahren zum Herstellen einer Leitungsanordnung**
Testing system for testing a cable assembly and method for manufacturing a cable assembly
Système de contrôle d'un agencement de conduite et procédé de fabrication d'un agencement de conduite

(30) Priorität: 06.07.2009 DE 102009031892
(43) Veröffentlichungstag der Anmeldung: 12.01.2011
(73) Patentinhaber: Engberts Mess-, Steuer- und Regelsysteme GmbH, 26188 Edewecht (DE)
(72) Erfinder: Engberts, Uwe, 26188 Edewecht (DE); Decker, Rainer, 26349 Jade (DE); Xanke, Marco, 26129 Oldenburg (DE)
(74) Vertreter: Diehl & Partner GbR

(56) Entgegenhaltungen:
- WO-A1-01/36991
- DE-A1- 10 113 799
- DE-A1- 19 500 113
- DE-C1- 10 019 860
- US-A- 5 072 185
- US-A1- 2003 144 817
- US-B1- 7 112 969

## Beschreibung

Die Erfindung betrifft ein Prüfsystem zum Prüfen einer Leitungsanordnung, einen Adapter zur Verwendung in einem solchen Prüfsystem, ein Prüfgerät zur Verwendung in einem solchen Prüfsystem und ein Verfahren zum Herstellen einer Leitungsanordnung.

In elektrischen Systemen, welche mehrere räumlich voneinander getrennte Module aufweisen, werden herkömmlicherweise Leitungsanordnungen zur elektrischen Verbindung der Module eingesetzt. Eine solche Leitungsanordnung umfasst mehrere Verbinder, die zur Kopplung an entsprechende Verbinder der jeweiligen Module konfiguriert sind, und Leitungen, die jeweils Kontakte verschiedener Verbinder miteinander verbinden. Derartige Leitungsanordnungen werden üblicherweise auch als Kabelbäume bezeichnet, und die Verbinder umfassen üblicherweise Stecker, Buchsen oder dergleichen.

Da die Leitungsanordnung eine für die Funktion des elektrischen Systems wesentliche Komponente ist, besteht ein Bedarf danach, die Leitungsanordnung nach deren Herstellung und vor deren Integration in das elektrische System zu prüfen.

Aus DE 195 00 113 A1 ist ein Prüfsystem zum Prüfen einer Leitungsanordnung bekannt, welches eine Mehrzahl von Adaptern aufweist, die einerseits an ein Prüfgerät angeschlossen werden und die andererseits jeweils einen Verbinder aufweisen, der zur Kopplung an einen Verbinder der zu prüfenden Leitungsanordnung konfiguriert ist. Zur Prüfung einer Leitungsanordnung werden die Verbinder derselben an die Verbinder der Adapter gekoppelt, so dass das Prüfgerät mit den Kontakten der Verbinder der Leitungsanordnung elektrisch verbunden ist. Das Prüfgerät kann dann verschiedene elektrische Eigenschaften der Leitungsanordnung, wie beispielsweise Widerstände und Induktivitäten einzelner Leitungen und Isolationswiderstände und Kapazitäten zwischen verschiedenen Leitungen, prüfen. Insbesondere können hierdurch Fehler der Leitungsanordnung, wie beispielsweise unerwünschte Kurzschlüsse, Unterbrechungen oder falsch miteinander verbundene Kontakte von Verbindern ermittelt werden.

Das aus DE 195 00 113 A1 bekannte Prüfsystem weist eine Flexibilität dahingehend auf, dass es für die Prüfung von Leitungsanordnungen verschiedener Bauart umgerüstet werden kann. Zur Umrüstung des Prüfsystems von der Prüfung einer Leitungsanordnung zu der Prüfung einer anderen Leitungsanordnung werden die zuvor an das Prüfgerät angeschlossenen Adapter entfernt und die für die neue Leitungsanordnung benötigten Adapter werden an das Prüfgerät angeschlossen. Das Anschließen der Adapter an das Prüfgerät ist zeitaufwendig und selbst fehleranfällig.

Dokument US 2003/0144817 bezieht sich auf ein Testsystem zum Testen elektrischer Verbindungen. Adapter unterschiedlichen Typs sind mit einem Verbindungsanalysator verbindbar. Die Adapter weisen jeweils ein Modul auf, das Prozessorfunktionalitäten und einen Speicher aufweist. Der Verbindungsanalysator ist ausgebildet, die Daten des Speichers auszulesen und zu verwenden. Dadurch es dem Verbindungsanalysator möglich, zwischen den unterschiedlichen Adaptertypen zu unterscheiden. Ein weiteres Testsystem ist in US7112969 offenbart.

Entsprechend ist es eine Aufgabe der Erfindung, ein Prüfsystem zum Prüfen einer Leitungsanordnung, Adapter zur Verwendung in einem solchen Prüfsystem und ein Prüfgerät zur Verwendung in einem solchen Prüfsystem vorzuschlagen, welche eine Umrüstung des Prüfsystems zur Prüfung verschiedener Leitungsanordnungen erleichtern.

Ausführungsformen der Erfindung stellen einen Adapter bereit, um Verbinder einer zu prüfenden Leitungsanordnung mit einem Prüfgerät zu verbinden. Hierzu umfasst der Adapter einen ersten Verbinder, der zur Kopplung an einen entsprechenden Verbinder der zu prüfenden Leitungsanordnung konfiguriert ist, einen zweiten Verbinder zum Anschluss an das Prüfgerät und ein Bündel von Leitungen, welche Kontakte des ersten Verbinders mit Kontakten des zweiten Verbinders verbinden. Ferner umfasst der Adapter einen Datenspeicher mit Anschlüssen, welche mit Kontakten des zweiten Verbinders verbunden sind. Der zweite Verbinder hat damit zwei Funktionen: Zum einen wird über diesen die elektrische Verbindung zwischen dem Prüfgerät und den Verbindern der zu prüfenden Leitungsanordnung hergestellt und zum anderen wird über diesen eine elektrische Verbindung zwischen dem Prüfgerät und dem Datenspeicher des Adapters geschaffen, so dass das Prüfgerät den Datenspeicher über den zweiten Verbinder des Adapters auslesen kann.

Es ist möglich, in dem Datenspeicher des Adapters Daten zu speichern, welche den Adapter kennzeichnen und insbesondere eindeutig identifizierbar machen. Der Adapter ermöglicht es somit, dass ein Prüfgerät, an welches der Adapter mit dessen zweitem Verbinder angeschlossen ist, die Art des Adapters und eine Anschlussposition des Adapters an dem Prüfgerät ermitteln kann. Hierzu muss das Prüfgerät lediglich eine Serie von Ausleseversuchen nacheinander über verschiedene Kombinationen von seinen Anschlüssen vornehmen und ein Ergebnis diesr Ausleseversuche auswerten. Nur bei einer Kombination von Anschlüssen hat der Ausleseversuch für einen bestimmten Adapter Erfolg, so dass auf diese Weise festgestellt ist, an welchen Anschlüssen der zweite Verbinder des Adapters angeschlossen ist, wobei dann der ausgelesene Dateninhalt des Datenspeichers Aufschluss über die Identität des angeschlossenen Adapters gibt.

Gemäß Ausführungsform der Erfindung ist der Datenspeicher in dem zweiten Verbinder des Adapters, welcher zum Anschluss an das Prüfgerät vorgesehen ist, angeordnet.

Gemäß alternativer Ausführungsformen hierzu ist der Datenspeicher in dem ersten Verbinder, welcher zum Anschluss an den Verbinder der zu prüfenden Leitungsanordnung konfiguriert ist, angeordnet und durch Leitungen des Leitungsbündels mit den Kontakten des zweiten Verbinders verbunden.

Gemäß weiterer Ausführungsformen der Erfindung sind die Kontakte des zweiten Verbinders, welche mit einem Anschluss des Datenspeichers verbunden sind, nicht mit Kontakten des ersten Verbinders verbunden. Dies kann den Vorteil aufweisen, dass der Datenspeicher die Messung von elektrischen Eigenschaften der Leitungsanordnung nicht beeinflussen kann. Gemäß weiterer Ausführungsformen der Erfindung ist wenigstens ein Kontakt des zweiten Verbinders, welcher mit einem Anschluss des Datenspeichers verbunden ist, ebenfalls mit einem der Kontakte des ersten Verbinders des Adapters verbunden. Dies hat den Vorteil, dass im Vergleich zu der vorangehend erläuterten Ausführungsform an dem zweiten Verbinder eine geringere Anzahl von Kontakten bereitgestellt werden muss.

Gemäß Ausführungsformen der Erfindung ist ein Prüfgerät zum Prüfen einer Leitungsanordnung bereitgestellt, welches eine Anschlussbaugruppe, an der eine Vielzahl von Kontakten gehaltert ist und welche zum Anschluss von Adaptern vorgesehen sind, eine Messvorrichtung mit wenigstens zwei Anschlüssen zum Messen wenigstens einer elektrischen Eigenschaft, eine Speicherauslesevorrichtung mit wenigstens zwei Anschlüssen und eine Schaltmatrix umfasst, um wahlweise die Anschlüsse der Messvorrichtung oder die Anschlüsse der Speicherauslesevorrichtung mit Kontakten der Anschlussbaugruppe zu verbinden. Es ist somit möglich, durch Betätigen der Schaltmatrix die Anschlüsse der Speicherauslesevorrichtung nacheinander mit verschiedenen Kombinationen von Kontakten der Anschlussbaugruppe zu verbinden und durch die Speicherauslesevorrichtung jeweils einen Speicherausleseversuch vorzunehmen, um festzustellen, über welche Kontakte der Anschlussbaugruppe welcher Adapter angeschlossen ist. Aufgrund der festen Geometrie der zweiten Verbinder der Adapter ist dann auch festgelegt, welche Kontakte der Anschlussbaugruppe mit Kontakten der Verbinder der zu prüfenden Leitungsanordnung verbunden sind. Die Schaltmatrix kann dann dahingehend angesteuert werden, die Messvorichtung nacheinander mit verschiedenen Kombinationen der Kontakte der Anschlussbaugruppe zu verbinden, um über diese Messungen der elektrischen Eigenschaften der zu prüfenden Leitungsanordnung vorzunehmen und die Ergebnisse dieser Messungen mit Informationen zu vergleichen, die beispielsweise in einem Speicher oder einer Datenbank des Prüfgeräts abgelegt sind, um hieraus einen Fehler der Leitungsanordnung zu ermitteln.

Die Kontakte der Anschlussbaugruppe sind nebeneinander derart angeordnet, dass die zweiten Verbinder der Adapter in einer Vielzahl verschiedener Positionen mit der Anschlussbaugruppe in Eingriff gebracht werden können. Bei dem herkömmlichen Prüfgerät war es notwendig, den zweiten Verbinder eines jeden Adapters an einer für diesen vorbestimmten Stelle mit den Kontakten der Anschlussbaugruppe in Eingriff zu bringen, um eine nachfolgende korrekte Prüfung der Leitungsanordnung zu ermöglichen. War der Verbinder an einer falschen Stelle mit der Anschlussbaugruppe in Eingriff gebracht, ergab sich ein falsches Prüfergebnis und es musste entweder die Position des Verbinders an der Anschlussbaugruppe korrigiert werden oder es musste der Ablauf der Messung abgeändert werden, um der falschen Kontaktierung Rechnung zu tragen. Indem gemäß Ausführungsformen der Erfindung die Speicherauslesevorrichtung über die Schaltmatrix mit den Kontakten der Anschlussbaugruppe verbunden werden kann, ist eine automatische Identifizierung der Positionen, an welchen bestimmte Adapter über deren zweite Verbinder an die Anschlussbaugruppe angeschlossen sind, möglich, so dass auch das zum Testen der Leitungsanordnung nötige Messverfahren an die jeweilige Anschlusssituation angepasst werden kann.

Gemäß Ausführungsformen der Erfindung umfasst das Prüfgerät hierzu eine Rechnersteuerung, welche die Schaltmatrix, die Speicherauslesevorrichtung und die Messvorrichtung ansteuert und welche Ergebnisse von Speicherausleseversuchen von der Speicherauslesevorrichtung und Ergebnisse von Messungen von der Messvorrichtung empfängt und diese Ergebnisse mit in einem Speicher gespeicherten Informationen zu einer Konfiguration der zu prüfenden Leitungsanordnung vergleicht, um einen Fehler in der zu prüfenden Leitungsanordnung zu ermitteln.

Gemäß weiterer Ausführungsformen der Erfindung ist ein Prüfsystem vorgesehen, welches wenigstens einen Adapter, wie er vorangehend beschrieben wurde, und ein Prüfgerät umfasst, wie es vorangehend beschrieben wurde.

Ein Verfahren zum Herstellen einer Leitungsanordnung gemäß Ausführungsformen der Erfindung umfasst: Koppeln von Verbindern der Leitungsanordnung an erste Verbinder von Adaptern eines Prüfsystems, Ansteuern einer Schaltmatrix des Prüfsystems derart, dass die wenigstens zwei Anschlüsse der Messvorrichtung des Prüfsystems der Reihe nach mit verschieden Kontakten der Verbinder der Leitungsanordnung verbunden sind und Ausführen von wenigstens einer Messung wenigstens einer elektrischen Eigenschaft durch eine Messvorrichtung des Prüfsystems bei verschiedenen Ansteuerungen der Schaltmatrix. Die durch die Messvorrichtung durchgeführten Messungen werden ausgewertet, und Fehler in der Leitungsanordnung können ermittelt werden. Gemäß Ausführungsformen der Erfindung umfasst das Herstellverfahren ferner ein Beheben des ermittelten Fehlers in der Leitungsanordnung durch Ändern einer Konfiguration der Leitungsanordnung, wie beispielsweise Ändern eines Anschlussmusters von Leitungen der Leitungsanordnung an Kontakte von Verbindern derselben.

Ausführungsformen der Erfindung werden nachfolgend anhand von Figuren näher erläutert. Hierbei zeigt:
- Figur 1: eine schematische Darstellung eines Prüfsystems zum Prüfen einer Leitungsanordnung gemäß einer Ausführungsform der Erfindung,
- Figur 2: eine schematische Darstellung eines in dem in Figur 1 gezeigten Prüfsystem verwendbaren Adapters gemäß einer zweiten Ausführungsform der Erfindung,
- Figur 3: eine schematische Darstellung einer Anschlussbaugruppe eines Prüfgeräts gemäß einer dritten Ausführungsform der Erfindung, und
- Figur 4: eine schematische Darstellung einer Anschlussbaugruppe eines Prüfgeräts gemäß einer vierten Ausführungsform der Erfindung.

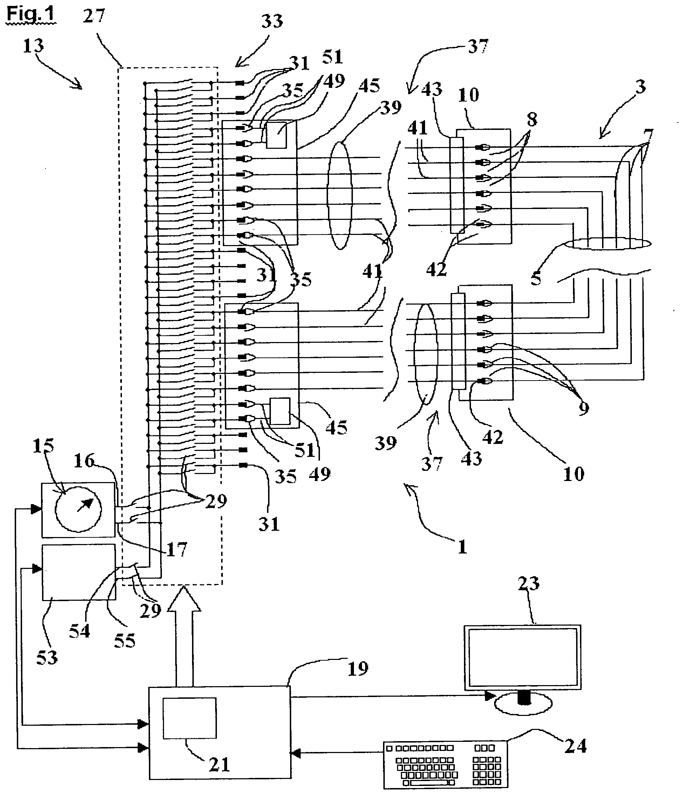

Figur 1 zeigt in schematischer Darstellung ein Prüfsystem 1 zum Prüfen einer Leitungsanordnung 3 gemäß einer Ausführungsform der Erfindung. Die zu prüfende Leitungsanordnung 3 umfasst ein Bündel 5 aus einer Mehrzahl von Leitungen 7, wobei eine jede Leitung 7 zwei Endkontakte 8 bzw. 9 elektrisch miteinander verbindet. Die Endkontakte 8 bzw. 9 sind in Verbindern 10 mechanisch gehaltert, wobei die Verbinder 10 dazu konfiguriert sind, an entsprechende Verbinder von Modulen eines elektrischen Systems gekoppelt zu werden, in welches die Leitungsanordnung 3 integriert werden soll. Die Verbinder 10 können als Stecker oder Buchsen oder dergleichen ausgebildet sein und neben der Funktion der elektrischen Kontaktierung der Kontakte 8, 9 auch noch andere Funktionen, wie etwa Spritzwasserschutz oder Ankopplung von Wasser- oder Druckluftschläuchen bereitstellen. Aufgabe des Prüfsystems 1 ist es, die elektrische Funktion der Leitungsanordnung 3 zu prüfen. Die Prüfung beinhaltet eine Überprüfung dahingehend, ob die gewünschten Kontakte 8 und 9 elektrisch miteinander verbunden sind und ein Verbindungswiderstand kleiner als ein gewünschter Wert ist, ob nicht beispielsweise zwischen zwei Kontakten 8 ein unerwünschter Kurzschluss vorliegt oder ob ein Isolationswiderstand zwischen verschiedenen Kontakten 8 größer ist als ein vorbestimmter Wert. Die Prüfung kann auch Messungen von Kapazitäten zwischen verschiedenen Leitungen und von Induktivitäten einzelner Leitungen umfassen. Das Prüfsystem 1 kann allerdings auch dahingehend erweitert sein, dass andere Funktionen der Leitungsanordnung 3, wie sie vorangehend erwähnt wurden, überprüft werden. Darüber hinaus ist die Leitungsanordnung 3 für die Zwecke der leichteren Darstellung in Figur 1 als einfache Leitungsanordnung mit lediglich sechs Leitungen 7 und zwei Verbindern 10 dargestellt. In der Praxis können zu prüfende Leitungsanordnungen wesentlich komplexer sein und wesentlich mehr Leitungen umfassen, deren Bündel zu einer Vielzahl von Steckern verzweigt sind.

Das Prüfsystem 1 umfasst Adapter 37, die nachfolgend in Details erläutert werden, und ein Prüfgerät 13. Das Prüfgerät 13 umfasst eine Messvorrichtung 15 mit zwei Anschlüssen 16 und 17, welche dazu konfiguriert ist, wenigstens eine elektrische Eigenschaft einer elektrischen Schaltung zu messen, die an die Anschlüsse 16, 17 angeschlossen ist. Die elektrische Eigenschaft kann einen Ohm'schen Widerstand, eine Kapazität und eine Induktivität umfassen. In dem hier erläuterten Ausführungsbeispiel weist die Messvorrichtung 15 zwei Anschlüsse 16 und 17 auf. Es ist jedoch auch möglich, dass die Messvorrichtung eine größere Zahl von Anschlüssen aufweist. Beispielsweise kann eine Messvorrichtung mit vier Anschlüssen vorgesehen sein, um eine 4-Pol-Messung der elektrischen Eigenschaften zu ermöglichen.

Zur Prüfung der Leitungsanordnung 3 sind die beiden Anschlüsse 16, 17 der Messvorrichtung 15 mit den Kontakten 8, 9 der Leitungsanordnung 3 in verschiedener Kombination zu verbinden, so dass durch die Messvorrichtung 15 Messungen an der Leitungsanordnung 3 vorgenommen werden können und mit vorbestimmten Sollwerten für die jeweiligen Messungen verglichen werden können, um eine Korrektheit der Konfiguration der Leitungsanordnung 3 festzustellen oder einen Fehler in der Leitungsanordnung 3 zu erkennen. Hierzu wird die Messvorrichtung 15 von einer Rechnersteuerung 19 gesteuert, welche ebenfalls Messergebnisse der Messanordnung 15 ausliest und die entsprechenden Vergleichsrechnungen durchführt. Die Rechnersteuerung 19 umfasst einen Speicher 21, in welchem Information zu der Konfiguration der zu prüfenden Leitungsanordnung 3 und gegebenenfalls zu weiteren Leitungsanordnungen anderer Bauart, welche nachfolgend geprüft werden können, gespeichert sind. An die Rechnersteuerung 19 können die üblichen Ausgabevorrichtungen, wie beispielsweise ein Bildschirm 23, und Eingabevorrichtungen, wie beispielsweise eine Tastatur 24, angeschlossen sein.

Das Prüfgerät 13 umfasst ferner eine Schaltmatrix 27, die durch die Rechnersteuerung 19 kontrolliert wird. Die Schaltmatrix 27 umfasst eine Vielzahl einzelner Schalter 29, um die Anschlüsse 16, 17 der Messvorrichtung 15 wahlweise mit Kontakten 31 zu verbinden, welche an einer Anschlussbaugruppe 33 des Prüfgeräts 13 bereitgestellt sind. Die Anschlussbaugruppe 33 haltert diese Kontakte 31 derart, dass diese von außen zugänglich sind und mit Kontakten 35 der Adapter 37 verbunden werden können, die zur Kopplung der Verbinder 10 der zu prüfenden Leitungsanordnung 3 an das Prüfgerät 37 dienen. Hierzu umfassen die Adapter 37 jeweils ein Bündel 39 von Leitungen 41, die jeweils einerseits Kontakte 42 zur Verbindung mit den Kontakten 8, 9 der Leitungsanordnung 3 mit den Kontakten 35 zur Verbindung mit den Kontakten 31 der Anschlussbaugruppe 33 andererseits miteinander verbinden. Die Kontakte 42 des Adapters 37 sind an einem Verbinder 43 gehaltert, der dazu konfiguriert ist, an einen entsprechenden Verbinder 10 der Leitungsanordnung 3 gekoppelt zu werden. Die Kontakte 35 sind an einem Verbinder 45 gehaltert, welcher so konfiguriert ist, dass er durch Anbringen an einer geeigneten Position der Anschlussbaugruppe 33 die Kontakte 35 des Verbinders 45 gleichzeitig mit einer Gruppe von einander benachbarten Kontakten 31 der Anschlussbaugruppe 33 in Verbindung bringt. Hierbei kann der Verbinder 45 an verschiedenen, auswählbaren Stellen an die Anschlussbaugruppe 33 gekoppelt werden, so dass die Kontakte 35 des Verbinders 45 in Abhängigkeit von der gewählten Stelle andere Gruppen von Kontakten 31 der Verbindungsbaugruppe 33 kontaktieren.

Um jedoch eine erfolgreiche Prüfung der Leitungsanordnung 3 vornehmen zu können, ist eine Kenntnis darüber, an welche Kontakte 31 der Anschlussbaugruppe 33 die Kontakte 8, 9 der Leitungsanordnung 3 angeschlossen sind, wesentlich, um die Schaltmatrix 27 zur Durchführung eines gewünschten Messprogramms anzusteuern.

Das Prüfgerät 13 ist dazu konfiguriert, Positionen, an welchen die Verbinder 45 an der Anschlussbaugruppe 33 angeschlossen sind, automatisch zu erkennen. Hierzu umfasst der Adapter 37 einen Speicher 49 mit Anschlüssen 51, die ebenfalls an durch den Verbinder 45 bereitgestellten Kontakten 31 angeschlossen sind, so dass die Anschlüsse 51 des Speichers 49 mit den Kontakten 31 der Anschlussbaugruppe 33 in Kontakt stehen, sobald der Verbinder 45 an die Anschlussbaugruppe 33 angeschlossen ist.

In dem dargestellten Ausführungsbeispiel sind die Speicherauslesevorrichtung 53 und die Messvorrichtung 15 separate Komponenten, die über jeweils eigene Anschlüsse 54, 55; 16, 17 an die Schaltmatrix 27 angeschlossen sind. Es ist jedoch auch möglich, die Speicherauslesevorrichtung und die Messvorrichtung als separate Komponenten parallel zu schalten, so dass sie mit gemeinsamen Anschlüssen an die Schaltmatrix angeschlossen sind. Die Steuerung 19 kann dann entweder die eine oder die andere der Speicherauslesevorrichtung und der Messvorrichtung betreiben. Ferner ist es möglich, die Speicherauslesevorrichtung und die Messvorrichtung in einer Messkomponente, wie beispielsweise einem einzigen Elektronikbaustein, zu vereinigen, welche an die Schaltmatrix mit zwei oder mehr Anschlüssen angeschlossen ist. Die Steuerung kann dann dieses gemeinsame Modul wahlweise in einem Modus zur Durchführung der Messung der wenigstens einen elektrischen Eigenschaft oder dem anderen Modus zum Auslesen der Datenspeicher betreiben, während die Schaltmatrix angesteuert wird, die der einen Seite der Schaltmatrix zugeführten Anschlüsse der Messkomponente, welche beide Funktionen vereinigt, wahlweise mit den Kontakten 31 auf der anderen Seite der Schaltmatrix zu verbinden.

Das Prüfgerät 13 umfasst ferner eine Speicherauslesevorrichtung 53 mit Anschlüssen 54 und 55, welche an die Schaltmatrix 27 angeschlossen sind, so dass Schalter 29 der Schaltmatrix 27 durch die Rechnersteuerung 19 so betätigt werden können, dass die Anschlüsse 54 und 55 der Speicherauslesevorrichtung 53 mit den Anschlüssen 51 des Speichers 49 verbunden sind. Bei einer derartigen Ansteuerung der Schaltmatrix 27 kann die Speicherauslesevorrichtung 53 den Inhalt des Speichers 49 auslesen und an die Rechnersteuerung 19 übermitteln. Der Inhalt des Speichers 49 kann Information enthalten, die es ermöglicht, den Adapter 37 eindeutig zu identifizieren und damit auch den Typ des Verbinders 10 der Leitungsanordnung 3 zu identifizieren, der über dem Verbinder 45 an die Anschlussbaugruppe 33 angeschlossen ist.

Darüber hinaus ist es möglich, den Verbinder 45 an einer beliebigen Position der Anschlussbaugruppe 33 an diese anzuschließen und sodann ein Programm auszuführen, welches es ermöglicht, die Position zu ermitteln, an welcher ein bestimmter Adapter 37 mit seinem Verbinder 45 an die Anschlussbaugruppe 33 angeschlossen ist. Hierzu steuert die Rechnersteuerung 19 die Schaltmatrix 27 der Reihe nach so an, dass die Anschlüsse 54, 55 der Speicherauslesevorrichtung mit verschiedenen Kombinationen von Paaren der Anschlüsse 31 der Anschlussbaugruppe 33 verbunden sind. Bei einer jeden Kombination der mit den Anschlüssen 54, 55 verbundenen Kontakte 31 veranlasst die Rechnersteuerung 19 einen Speicherausleseversuch durch die Speicherauslesevorrichtung 53. Dieser Ausleseversuch wird nur dann Erfolg haben, wenn durch die Schaltmatrix das Paar von Kontakten 31 mit den Anschlüssen 54, 55 der Speicherauslesevorrichtung 53 verbunden ist, an welche die Anschlüsse 51 des Speichers 49 des Adapters 37 angeschlossen sind. Dann liefert der Speicherausleseversuch zudem noch die Information zur Identifizierung des angeschlossenen Adapters 37. Durch systematische Ansteuerung der Schaltmatrix und Durchführen eines Speicherausleseversuchs bei einer jeden Ansteuerung der Schaltmatrix ist es somit möglich, die Position der Kontakte 31 an der Anschlussbaugruppe 33 festzustellen, an welche ein Verbinder 45 eines bestimmten Adapters 37 angeschlossen ist.

Falls der Verbinder 45 in mehreren Orientierungen an die Anschlussbaugruppe 33 gekoppelt werden kann, so ist es auch möglich, diese Orientierung im Rahmen des erläuterten Programms festzustellen. Figur 1 zeigt den Anschluss der Verbinder 45 in zwei Orientierungen, indem bei dem in Figur 1 oben dargestellten Verbinder 45 der Speicherbaustein 49 in dem Verbinder 45 oben angeordnet ist, während er in dem in Figur 1 unten dargestellten Verbinder 45 unten angeordnet ist. Der Speicher 49 ist in dem Verbinder 45 derart angeordnet, dass der Speicherausleseversuch nur dann Erfolg hat, wenn beispielsweise der Anschluss 54 der Speicherauslesevorrichtung 53 über die Schaltmatrix 27 mit dem am Rand des Verbinders 45 angeordneten und mit dem Speicher 49 verbundenen Kontakt 31 verbunden ist, während der Anschluss 55 der Speicherauslesevorrichtung 53 mit dem von dem Rand des Verbinders 45 entfernt angeordneten und mit dem Speicher 49 verbundenen Kontakt 35 des Verbinders 45 verbunden ist.

Durch Ausführen des erläuterten Programms durch die Rechnersteuerung 19, d.h. durch das systematische Verbinden der Anschlüsse 54, 55 der Speicherauslesevorrichtung 53 nacheinander mit verschiedenen Kombinationen von Paaren von Kontakten 31 der Anschlussbaugruppe 33 ist es somit möglich, die an die Anschlussbaugruppe 33 angeschlossenen Adapter 37 zu identifizieren und die Positionen zu bestimmen, an denen die Verbinder 45 der Adapter 37 an die Anschlussbaugruppe 33 angeschlossen sind. Die Rechnersteuerung 19 kann dann das Programm zur Messung der elektrischen Eigenschaften der Leitungsanordnung 3 ausführen, indem die Anschlüsse 16, 17 der Messvorrichtung 15 nacheinander mit verschiedenen Paaren der Anschlüsse 31 der Anschlussbaugruppe 33 verbunden werden und bei einer jeden Ansteuerung der Schaltmatrix 27 eine oder mehrere elektrische Eigenschaften der Leitungsanordnung 3 gemessen werden.

Aufgrund der automatischen Erkennung der an die Anschlussbaugruppe 33 angeschlossenen Adapter 37 und der Erkennung der Positionen, an denen diese angeschlossen sind, ist es möglich, das Prüfsystem 1 sehr einfach von einer Konfiguration zur Prüfung einer Leitungsanordnung in eine Konfiguration zur Prüfung einer anderen Leitungsanordnung, die eine von der einen Leitungsanordnung verschiedene Bauart aufweist, umzurüsten. Eine Person die die Umrüstung vornimmt kann nämlich die für die Prüfung der jeweilen Leitungsanordnung notwendigen Adapter an beliebigen freien Positionen der Anschlussbaugruppe 33 anschließen, ohne darauf achten zu müssen, dass die Verbinder der Adapter etwa an vorbestimmten Positionen in vorbestimmten Orientierungen angebracht werden müssen.

Nachfolgend werden weitere Ausführungsformen der Erfindung im Zusammenhang mit den Figuren erläutert. Hierbei werden Komponenten, die sich hinsichtlich ihrer Struktur und Funktion entsprechen, mit Bezugszeichen versehen, die gleichen Ziffern aufweisen, wie sie für die Beschreibung der ersten Ausführungsform anhand der Figur 1 verwendet wurden, die jedoch zur Unterscheidung mit einem zusätzlichen Buchstaben ergänzt sind. Zur Erläuterung dieser Komponenten ist deshalb auf die gesamte jeweils vorangehende und nachfolgende Beschreibung Bezug zu nehmen.

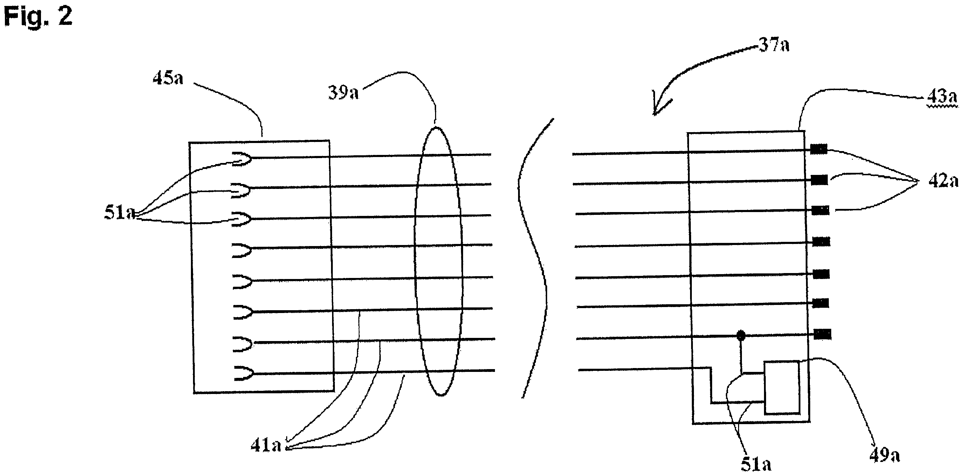

Figur 2 zeigt in schematischer Darstellung eine Ausführungsform eines Adapters 37a zum Anschluss einer zu prüfenden Leitungsanordnung (in Figur 2 nicht dargestellt) an eine Anschlussbaugruppe eines Prüfgeräts (in Figur 2 nicht dargestellt). Hierzu umfasst der Adapter 37a eine Mehrzahl von Leitungen 41a, welche Kontakte 51a einerseits mit Kontakten 42a andererseits verbinden. Die Kontakte 42a sind an einem Verbinder 43a gehaltert, welcher zum Anschluss an einen entsprechenden Verbinder der zu prüfenden Leitungsanordnung konfiguriert ist. Die Kontakte 51a sind an einem Verbinder 45a gehaltert, welcher zum Anschluss an die Anschlussbaugruppe des Prüfgeräts konfiguriert ist. Im Unterschied zu der anhand der Figur 1 erläuterten Ausführungsform ist ein Speicher 49a des Adapters 37a nicht in dem Verbinder 45a, der zum Anschluss an die Anschlussbaugruppe konfiguriert ist, angeordnet, sondern in dem Verbinder 43a, der zum Anschluss an den entsprechenden Verbinder der zu prüfenden Leitungsanordnung konfiguriert ist. Anschlüsse 51a der Speicheranordnung 49a sind über Leitungen 41a des Leitungsbündels 39a mit den Kontakten 51a verbunden, so dass der Inhalt des Speichers 49a über die Kontakte 51a auslesbar ist.

Figur 2 illustriert auch eine weitere Ausführungsform der Erfindung, gemäß der einer der Anschlüsse 51a des Speichers 49a an einen Kontakt 51a angeschlossen ist, welcher zusätzlich auch an einen der Kontakte 42a angeschlossen ist, die zur Kopplung an Kontakte der zu prüfenden Leitungsanordnung vorgesehen sind. Dieser Kontakt stellt somit zwei Funktionen bereit: Er kann dazu eingesetzt werden, den Inhalt des Speichers 49a auszulesen, und er kann auch dazu eingesetzt werden, Messungen von elektrischen Eigenschaften der zu prüfenden Leitungsanordnung vorzunehmen.

Bei der in der Figur 1 dargestellten Ausführungsform weist der Speicher 49a zwei Anschlüsse auf, und lediglich einer der Anschlüsse ist mit einem der Kontakte 51a verbunden, die auch zum Messen der elektrischen Eigenschaften eingesetzt werden. Es ist jedoch auch möglich, dass beide Anschlüssen 51a des Speichers 49a mit derartigen Kontakten 51a verbunden sind, und es ist ferner möglich, dass der Speicher 49a mehr als zwei Anschlüsse aufweist, die ganz, teilweise oder gar nicht mit solchen Anschlüssen verbunden sind, die auch für die Messung der elektrischen Eigenschaften eingesetzt werden.

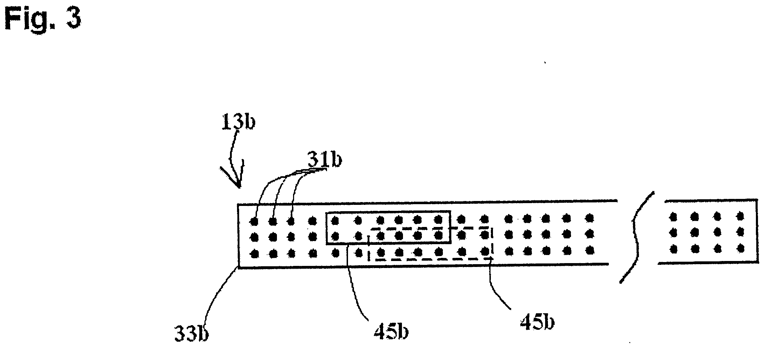

Figur 3 zeigt eine Draufsicht auf Kontaktstifte 31b einer Anschlussbaugruppe 33b zum Anschluss von Verbindern von Adaptern zum Anschluss einer zu prüfenden Leitungsanordnung. In der in Figur 3 dargestellten Ausführungsform sind die Kontakte 31b in drei Reihen nebeneinander als regelmäßiges Gitter angeordnet. Gemäß anderen Ausführungsformen können Anordnungen von Kontakten in einzelnen, doppelten oder mehr als drei Reihen vorgesehen sein. Ein durchgezogenes Rechteck in Figur 3 repräsentiert einen Verbinder 45b zur Kontaktierung von 2 x 6 = 12 Kontakten 31b. Ein mit unterbrochenen Linien dargestelltes Rechteck 45b' repräsentiert eine weitere mögliche Position, an der der Verbinder mit der Anschlussbaugruppe 33b gekoppelt werden kann, um 12 Kontakte 31b zu kontaktieren. Es ist ersichtlich, dass der Verbinder 45b in einer Vielzahl von zueinander versetzten Positionen an die Anschlussbaugruppe 33b angeschlossen werden kann. Aufgrund des in dem Adapter vorgesehenen Speichers ist es jedoch möglich, dass eine Steuerung die tatsächliche Anschlussposition des Verbinders erkennen kann, um in Abhängigkeit davon die Messung der elektrischen Eigenschaften über die Schaltmatrix zu steuern.

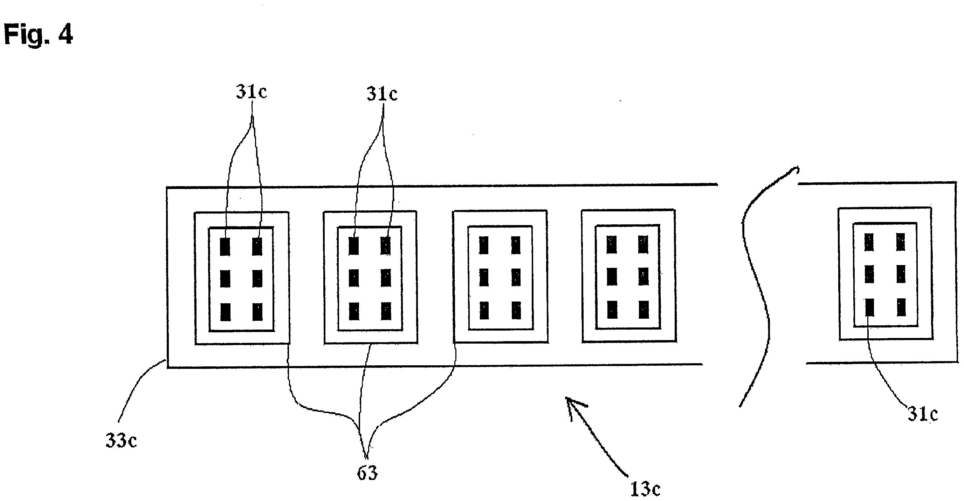

Figur 4 ist eine Teilansicht eines Prüfgeräts 13c gemäß einer weiteren Ausführungsform der Erfindung. Das Prüfgerät 13c umfasst eine Anschlussbaugruppe 33c, bei welcher Gruppen von jeweils sechs Kontakten 31c an Verbindern 63 bereitgestellt sind. Die Verbinder 63 sind zum Anschluss von Verbindern (Bezugszeichen 45 in Figur 1) von Adaptern (Bezugszeichen 37 in Figur 1) konfiguriert, an welche zu prüfende Leitungsanordnungen angeschlossen werden können. Ein jeder Verbinder des Adapters kann damit an verschiedene freie Verbinder 63 der Anschlussbaugruppe 33c angeschlossen werden, um eine Gruppe von sechs Kontakten 31c zu kontaktieren. Wiederum dient ein in dem Adapter vorgesehener Speicher dazu, die Position an der Anschlussbaugruppe 33c bzw. den Verbinder 63 zu ermitteln, an welchen der jeweilige Adapter an die Anschlussbaugruppe 33c angeschlossen ist.

Ein Beispiel für einen im Zusammenhang mit Ausführungsformen der vorliegenden Erfindung einsetzbaren Datenspeicher ist ein 1024-Bit, 1-Wire EEPROM, welches unter der Bezeichnung DS2431 von der Firma MAXIM INTEGRATED PRODUCTS, INC., SUNNYVALE, CA, USA bezogen werden kann. Die Speicherauslesevorrichtung ist dazu konfiguriert, an die Anschlüsse des Datenspeichers eine Folge von elektrischen Signalen anzulegen und Messungen von elektrischen Eigenschaften vorzunehmen, welche gemäß Spezifikation des Datenspeichers zu dessen Auslesen nötig sind. Insbesondere kann die Messvorrichtung zur Messung der wenigstens einen Eigenschaft der Leitungsanordnung mit der Speicherauslesevorrichtung integriert sein.

Zusammenfassend sind gemäß Ausführungen der Erfindung Prüfsysteme zum Prüfen einer Leitungsanordnung vorgesehen, welche einen Speicher, der gemeinsam mit Messleitungen zum Prüfen der Leitungsanordnung an eine Seite einer Schaltmatrix anschließbar ist, umfassen. An die andere Seite der Schaltmatrix ist eine Messvorrichtung zum Messen wenigstens einer elektrischen Eigenschaft und eine Speicherauslesevorrichtung zum Auslesen des Speichers angeschlossen.

Obwohl die voranstehenden Ausführungsbeispiele der vorliegenden Erfindung lediglich beispielhaft erläutert worden sind, werden die Fachleute erkennen, dass zahlreiche Modifikationen, Hinzufügungen und Ersetzungen möglich sind, ohne von dem Schutzbereich der in den nachfolgenden Ansprüchen offenbarten Erfindung abzuweichen.

## Patentansprüche

1. Prüfsystem zum Prüfen einer Leitungsanordnung (3), wobei die Leitungsanordnung (3) eine Mehrzahl von durch Leitungen (7) verbundenen Verbindern (10) umfasst und wobei das Prüfsystem (1) umfasst:
wenigstens einen Adapter (37), der einen Datenspeicher (49), einen ersten Verbinder (43), der zur Kopplung an einen der Verbinder (10) der Leitungsanordnung (3) konfiguriert ist, einen zweiten Verbinder (45) und ein Bündel (39) von Leitungen (41) umfasst, welche Kontakte (42) des ersten Verbinders (43) mit Kontakten (35) des zweiten Verbinders (45) verbinden, und wobei Anschlüsse (51) des Datenspeichers (49) mit Kontakten (35) des zweiten Verbinders (45) verbunden sind;
ein Prüfgrät (13), umfassend
eine Anschlussbaugruppe (33), an der eine Vielzahl von Kontakten (31) gehaltert ist, wobei die Kontakte (35) des zweiten Verbinders (45) mit einer auswählbaren Gruppe von einander benachbarten Kontakten (35) der Anschlussbaugruppe (33) verbindbar sind; wobei die Kontakte (31) der Anschlussbaugruppe (33) nebeneinander derart angeordnet sind, dass der zweite Verbinder (45) in einer Vielzahl verschiedener Positionen mit der Anschlussbaugruppe (33) in Eingriff bringbar ist;
eine Messvorrichtung (15) mit wenigstens zwei Anschlüssen (16, 17), zum Messen wenigstens einer elektrischen Eigenschaft;
eine Speicherauslesevorrichtung (53) mit wenigstens zwei Anschlüssen (54, 55), zum Auslesen des Datenspeichers (49) des Adapters (37); und
eine Schaltmatrix (27) zum wahlweisen Verbinden der Anschlüsse (16, 17) der Messvorrichtung (15) und der Anschlüsse (54, 55) der Speicherauslesevorrichtung (53) einerseits mit den Kontakten (31) der Anschlussbaugruppe (33) andererseits;
**dadurch gekennzeichnet, dass** das Prüfgerät (33) ausgebildet ist, durch ein Betätigen der Schaltmatrix (27) die Anschlüsse der Speicherauslesevorrichtung (53) nacheinander mit verschiedenen Kombinationen von Kontakten der Anschlussbaugruppe (33) zu verbinden und durch die Speicherauslesevorrichtung (53) jeweils einen Speicherausleseversuch vorzunehmen und abhängig davon für den zweiten Verbinder (45) eine Position der Vielzahl an Positionen zu identifizieren, an welcher der Adapter (37) über den zweiten Verbinder (45) an der Anschlussbaugruppe (33) angeschlossen ist.

2. Prüfsystem nach Anspruch 1, wobei die Kontakte (31b) der Anschlussbaugruppe (33b) in wenigstens einer Reihe mit jeweils gleichen Abständen voneinander angeordnet sind und wobei der zweite Verbinder (45b) wahlweise an mehreren Positionen (45b') der Reihe anordenbar ist, um die Kontakte dieses zweiten Verbinders mit den Kontakten (31b) der Anschlussbaugruppe (33b) zu verbinden.

3. Prüfsystem nach Anspruch 1 oder 2, wobei die Anschlussbaugruppe (33c) eine Mehrzahl von Verbindern (63) aufweist, welche jeweils eine Gruppe von Kontakten (31c) der Anschlussbaugruppe (33c) umfassen und welche zur Kopplung mit den zweiten Verbindern der Adapter konfiguriert sind.

4. Prüfsystem nach einem der Ansprüche 1 bis 3, wobei der Datenspeicher (49) in dem zweiten Verbinder (45) des Adapters (37) angeordnet ist.

5. Prüfsystem nach einem der Ansprüche 1 bis 3, wobei der Datenspeicher (49a) in dem ersten Verbinder (43a) des Adapters (37a) angeordnet ist und wobei die Anschlüsse (51a) des Datenspeichers (49a) durch Leitungen (41a) des Bündels (39a) von Leitungen mit den Kontakten (51a) des zweiten Verbinders (45a) verbunden sind.

6. Prüfsystem nach einem der Ansprüche 1 bis 5, wobei sämtliche Kontakte (35) des zweiten Verbinders (45), welche mit einem Anschluss (51) des Datenspeichers (49) verbunden sind, nicht mit Kontakten (42) des ersten Verbinders (43) verbunden sind.

7. Prüfsystem nach einem der Ansprüche 1 bis 5, wobei wenigstens ein Kontakt (51a) des zweiten Verbinders (45a), der mit einem Anschluss (51a) des Datenspeichers (49a) verbunden ist, auch mit einem der Kontakte (42a) des ersten Verbinders (43a) verbunden ist.

8. Verwendung eines Adapters in einem Prüfsystem nach einem der Ansprüche 1 bis 7, wobei der Adapter umfasst:
einen ersten Verbinder, der zur Kopplung an einen Verbinder einer zu prüfenden Leitungsanordnung konfiguriert ist;
einen zweiten Verbinder;
ein Bündel von Leitungen, welche Kontakte des ersten Verbinders mit Kontakten des zweiten Verbinders verbinden, und
einen Datenspeicher mit Anschlüssen, welche mit Kontakten des zweiten Verbinders verbunden sind.

9. Prüfgerät zum Prüfen einer Leitungsanordnung und zur Verwendung in einem Prüfsystem nach einem der Ansprüche 1 bis 7, wobei das Prüfgerät umfasst:
eine Anschlussbaugruppe, an der eine Vielzahl von Kontakten gehaltert ist; wobei die Kontakte (35) des zweiten Verbinders (45) mit einer auswählbaren Gruppe von einander benachbarten Kontakten (35) der Anschlussbaugruppe (33) verbindbar sind; wobei die Kontakte (31) der Anschlussbaugruppe (33) nebeneinander derart angeordnet sind, dass der zweite Verbinder (45) in einer Vielzahl verschiedener Positionen mit der Anschlussbaugruppe (33) in Eingriff bringbar ist;
eine Messvorrichtung mit wenigstens zwei Anschlüssen, zum Messen wenigstens einer elektrischen Eigenschaft;
eine Speicherauslesevorrichtung mit wenigstens zwei Anschlüssen, zum Auslesen von Datenspeichern in Adaptern, welche mit Verbindern an die Kontakte der Anschlussbaugruppe anschließbar sind; und
eine Schaltmatrix zum wahlweisen Verbinden der Anschlüsse der Messvorrichtung und der Anschlüsse der Speicherauslesevorrichtung einerseits mit den Kontakten der Anschlussbaugruppe andererseits;
**dadurch gekennzeichnet, dass** das Prüfgerät (33) ausgebildet ist, durch ein Betätigen der Schaltmatrix (27) die Anschlüsse der Speicherauslesevorrichtung (53) nacheinander mit verschiedenen Kombinationen von Kontakten der Anschlussbaugruppe (33) zu verbinden und durch die Speicherauslesevorrichtung (53) jeweils einen Speicherausleseversuch vorzunehmen und abhängig davon für den zweiten Verbinder (45) eine Position der Vielzahl an Positionen zu identifizieren, an welcher der Adapter (37) über den zweiten Verbinder (45) an die Anschlussbaugruppe (33) angeschlossen ist.

10. Prüfgerät nach Anspruch 9, ferner umfassend eine Rechnersteuerung mit einem Speicher, in dem Information zu wenigstens einer Konfiguration einer zu prüfenden Leitungsanordnung gespeichert ist.

11. Prüfgerät nach Anspruch 10, wobei die Rechnersteuerung dazu konfiguriert ist,
die Schaltmatrix derart anzusteuern, dass die wenigstens zwei Anschlüsse der Speicherauslesevorrichtung der Reihe nach mit verschieden Kontakten der Anschlussbaugruppe verbunden sind, und
bei einer jeden Ansteuerung der Schaltmatrix die Speicherauslesevorrichtung dazu anzusteuern, den Speicherausleseversuch vorzunehmen und ein Ergebnis des Speicherausleseversuchs an die Rechnersteuerung zu übermitteln.

12. Prüfgerät nach Anspruch 11, wobei die Rechnersteuerung ferner dazu konfiguriert ist, in Abhängigkeit der Ergebnisse der Speicherausleseversuche und der Information zu der Konfiguration der zu prüfenden Leitungsanordnung die Schaltmatrix derart anzusteuern, dass die wenigstens zwei Anschlüsse der Messvorrichtung der Reihe nach mit verschiedenen Kontakten der Anschlussbaugruppe verbunden sind, und bei einer jeden Ansteuerung der Schaltmatrix die Messvorrichtung dazu anzusteuern, die wenigstens eine elektrische Eigenschaft zu messen und ein Ergebnis der Messung an die Rechnersteuerung zu übermitteln.

13. Verfahren zum Herstellen einer Leitungsanordnung, wobei das Verfahren umfasst:
Koppeln von Verbindern der Leitungsanordnung an erste Verbinder von Adaptern des Prüfsystems nach einem der Ansprüche 1 bis 7,
Ansteuern der Schaltmatrix des Prüfsystems derart, dass die wenigstens zwei Anschlüsse der Messvorrichtung des Prüfsystems der Reihe nach mit verschieden Kontakten der Verbinder der Leitungsanordnung verbunden sind, und
Ausführen einer Messung durch die Messvorrichtung bei einer jeden Ansteuerung der Schaltmatrix.

14. Verfahren nach Anspruch 13, ferner umfassend Auswerten der durch die Messvorrichtung durchgeführten Messungen und Ermitteln eines Fehlers in der Leitungsanordnung.

15. Verfahren nach Anspruch 14, ferner umfassend Beheben des ermittelten Fehlers in der Leitungsanordnung.

## Claims

1. A test system for testing a lead wire assembly (3), wherein the lead wire assembly (3) comprises a plurality of connectors (10) connected by lead wires (7), and wherein the test system (1) comprises:
at least one adapter (37) having a data memory (49), a first connector (43) configured to be coupled to one of the connectors (10) of the lead wire assembly (3), a second connector (45) and a bundle (39) of lead wires (41) connecting contacts (42) of the first connector (43) with contacts (35) of the second connector (45), and wherein terminals (51) of the data memory (49) are connected with contacts (35) of the second connector (45);
a test device (13) comprising:
a terminal assembly (33) on which a plurality of contacts (31) is mounted, the contacts (35) of the second connector (45) being connectable to a selectable group of adjacent contacts (35) of the terminal assembly (33); wherein the contacts (31) of the terminal assembly (33) are arranged next to each other such that the second connector (45) is engageable with the terminal assembly (33) in a plurality of different positions;
a measuring device (15) with at least two terminals (16, 17) for measuring at least one electrical characteristic;
a memory readout device (53) having at least two terminals (54, 55) for reading out the data memory (49) of the adapter (37); and
a switching matrix (27) for selectively connecting the terminals (16, 17) of the measuring device (15) and the terminals (54, 55) of the memory readout device (53) on the one hand, to the contacts (31) of the terminal assembly (33), on the other hand;
**characterized in that** the test device (33) is adapted to successively connect the terminals of the memory readout device (53) to different combinations of contacts of the terminal assembly (33) by actuating the switching matrix (27) and to make a respective memory readout attempt by the memory readout device (53) and to identify a position of the plurality of positions for the second connector (45) depending thereon, to which positions the adapter (37) is connected to the terminal assembly (33) via the second connector (45).

2. The test system according to claim 1, wherein the contacts (31b) of the terminal assembly (33b) are arranged in at least one row at equal distances from each other, respectively, and wherein the second connector (45b) is selectively arrangeable at a plurality of positions (45b') of the row to connect the contacts of said second connector to the contacts (31b) of the terminal assembly (33b).

3. The test system according to claim 1 or 2, wherein the terminal assembly (33c) comprises a plurality of connectors (63) each comprising a group of contacts (31c) of the terminal assembly (33c) and configured for coupling to the second connectors of the adapters.

4. The test system according to any of claims 1 to 3, wherein the data memory (49) is disposed in the second connector (45) of the adapter (37).

5. The test system according to one of claims 1 to 3, wherein the data memory (49a) is arranged in the first connector (43a) of the adapter (37a), and wherein the terminals (51a) of the data memory (49a) are connected to the contacts (51a) of the second connector (45a) through lead wires (41a) of the bundle (39a) of lead wires.

6. The test system according to one of claims 1 to 5, wherein all contacts (35) of the second connector (45) connected to a terminal (51) of the data memory (49) are not connected to contacts (42) of the first connector (43).

7. The test system according to any of claims 1 to 5, wherein at least one contact (51a) of the second connector (45a) connected to a terminal (51a) of the data memory (49a) is also connected to one of the contacts (42a) of the first connector (43a).

8. Usage of an adapter in a test system according to any of claims 1 to 7, wherein the adapter comprises:
a first connector configured to be coupled to a connector of a lead wire assembly to be tested;
a second connector;
a bundle of lead wires connecting contacts of the first connector to contacts of the second connector, and
a data memory with terminals connected to contacts of the second connector.

9. A test device for testing a lead wire assembly and for usage in a test system according to any one of claims 1 to 7, the test device comprising:
a terminal assembly on which a plurality of contacts are mounted; wherein the contacts (35) of the second connector (45) are connectable to a selectable group of adjacent contacts (35) of the terminal assembly (33); wherein the contacts (31) of the terminal assembly (33) are arranged next to each other such that the second connector (45) is engageable with the terminal assembly (33) in a plurality of different positions;
a measuring device with at least two terminals for measuring at least one electrical characteristic;
a memory readout device with at least two terminals for readout of data memories in adapters which can be connected by means of connectors to the contacts of the terminal assembly; and
a switching matrix for selectively connecting the terminals of the measuring device and the terminals of the memory readout device on the one hand to the contacts of the terminal assembly on the other hand;
**characterized in that** the test device (33) is adapted to successively connect the terminals of the memory readout device (53) with various combinations of contacts of the terminal assembly (33) by actuation of the switching matrix (27) and to perform a memory readout attempt by means of the memory readout device (53), respectively, and depending thereon to identify a position of the plurality of positions for the second connector (45) at which the adapter (37) is connected via the second connector (45) to the terminal assembly (33).

10. The test device according to claim 9, further comprising a computer controller having a memory in which information on at least one configuration of a lead wire assembly to be tested is stored.

11. The test device according to claim 10, wherein the computer controller is configured:
to control the switching matrix in such a way that the at least two terminals of the memory readout device are connected in sequence to different contacts of the terminal assembly, and
to control the memory readout device at each control of the switching matrix, to make the memory readout attempt and to transmit a result of the memory readout attempt to the computer controller.

12. The test device according to claim 11, wherein the computer controller is further configured to control the switching matrix depending on the results of the memory readout attempts and the information on the configuration of the lead wire assembly to be tested such that the at least two terminals of the measuring device are connected in sequence to different contacts of the terminal assembly, and to control the measuring device, for each control of the switching matrix, to measure the at least one electrical characteristic and to transmit a result of the measurement to the computer controller.

13. A method of manufacturing a lead wire assembly, the method comprising:
coupling of connectors of the lead wire assembly to first connectors of adapters of the test system according to any of claims 1 to 7,
controlling the switching matrix of the test system in such a way that the at least two terminals of the measuring device of the test system are connected in sequence to different contacts of the connectors of the lead wire assembly, and
performing a measurement by the measuring device with each control of the switching matrix.

14. The method according to claim 13, further comprising evaluating the measurements made by the measuring device and determining an error in the lead wire assembly.

15. The method according to claim 14, further comprising correcting the determined fault in the lead wire assembly.

## Revendications

1. Système de test servant à tester un ensemble de lignes (3), dans lequel l'ensemble de lignes (3) comprend une pluralité de connecteurs (10) connectés par des lignes (7) et dans lequel le système de test (1) comprend :
au moins un adaptateur (37), qui comprend une mémoire de données (49), un premier connecteur (43), qui est configuré pour le couplage à un des connecteurs (10) de l'ensemble de lignes (3), un deuxième connecteur (45) et un faisceau (39) de lignes (41) qui connectent des contacts (42) du premier connecteur (43) à des contacts (35) du deuxième connecteur (45), et dans lequel des raccordements (51) de la mémoire de données (49) sont connectés à des contacts (35) du deuxième connecteur (45) ;
un appareil de test (13), comprenant
un groupe de raccordement (33), sur lequel est fixée une pluralité de contacts (31), dans lequel les contacts (35) du deuxième connecteur (45) sont aptes à être connectés à un groupe sélectionnable de contacts (35) adjacents les uns aux autres du groupe de raccordement (33) ; dans lequel les contacts (31) du groupe de raccordement (33) sont disposés côte à côte de manière que le deuxième connecteur (45) soit apte à être amené en prise avec le groupe de raccordement (33) dans une pluralité de positions différentes ;
un dispositif de mesure (15) avec au moins deux raccordements (16, 17) pour la mesure d'au moins une propriété électrique ;
un dispositif de lecture de mémoire (53) avec au moins deux raccords (54, 55) pour la lecture de la mémoire de données (49) de l'adaptateur (37) ; et
une matrice de commutation (27) pour la connexion au choix des raccordements (16, 17) du dispositif de mesure (15) et des raccordements (54, 55) du dispositif de lecture de mémoire (53) d'une part aux contacts (31) du groupe de raccordement (33) d'autre part ;
**caractérisé en ce que** l'appareil de test (33) est réalisé pour connecter, par un actionnement de la matrice de commutation (27), les raccordements du dispositif de lecture de matrice (53) les uns après les autres avec différentes combinaisons de contacts du groupe de raccordement (33) et, par le dispositif de lecture de mémoire (53), respectivement pour faire effectuer un essai de lecture de mémoire et pour identifier en fonction de ce qui précède pour le deuxième connecteur (45) une position de la pluralité de positions, sur laquelle l'adaptateur (37) est raccordé par l'intermédiaire du deuxième connecteur (45) au groupe de raccordement (33).

2. Système de test selon la revendication 1, dans lequel les contacts (31b) du groupe de raccordement (33b) sont disposés en au moins une rangée à des distances respectivement identiques les uns des autres et dans lequel le deuxième connecteur (45b) est disposable au choix sur plusieurs positions (45b') de la rangée, pour connecter les contacts de ce deuxième connecteur aux contacts (31b) du groupe de raccordement (33b).

3. Système de test selon la revendication 1 ou 2, dans lequel le groupe de raccordement (33c) présente une pluralité de connecteurs (63), qui comprennent respectivement un groupe de contacts (31c) du groupe de raccordement (33c) et qui sont configurés pour le couplage aux deuxièmes connecteurs des adaptateurs.

4. Système de test selon l'une des revendications 1 à 3, dans lequel la mémoire de données (49) est disposée dans le deuxième connecteur (45) de l'adaptateur (37).

5. Système de test selon l'une des revendications 1 à 3, dans lequel la mémoire de données (49a) est disposée dans le premier connecteur (43a) de l'adaptateur (37a) et dans lequel les raccordements (51a) de la mémoire de données (49a) sont connectés aux contacts (51a) du deuxième connecteur (45a) par des lignes (41a) du faisceau (39a) de lignes.

6. Système de test selon l'une des revendications 1 à 5, dans lequel tous les contacts (35) du deuxième connecteur (45) qui sont connectés à un raccordement (51) de la mémoire de données (49) ne sont pas connectés à des contacts (42) du premier connecteur (43).

7. Système de test selon l'une des revendications 1 à 5, dans lequel au moins un contact (51a) du deuxième connecteur (45a) qui est connecté à un raccordement (51a) de la mémoire de données (49a) est également connecté à un des contacts (42a) du premier connecteur (43a).

8. Utilisation d'un adaptateur dans un système de test selon l'une des revendications 1 à 7, dans lequel l'adaptateur comprend :
un premier connecteur, qui est configuré pour le couplage à un connecteur d'un ensemble de lignes à tester ;
un deuxième connecteur ;
un faisceau de lignes, qui connectent des contacts du premier connecteur à des contacts du deuxième connecteur, et
une mémoire de données avec des raccordements, lesquels sont connectés à des contacts du deuxième connecteur.

9. Appareil de test servant à tester un ensemble de lignes et pour l'utilisation dans un système de test selon l'une des revendications 1 à 7, dans lequel l'appareil de test comprend :
un groupe de raccordement, sur lequel est fixée une pluralité de contacts ; dans lequel les contacts (35) du deuxième connecteur (45) sont aptes à être connectés à un groupe sélectionnable de contacts (35) adjacents les uns aux autres du groupe de raccordement (33) ; dans lequel les contacts (31) du groupe de raccordement (33) sont disposés côte à côte de manière que le deuxième connecteur (45) soit apte à être amené en prise avec le groupe de raccordement (33) dans une pluralité de positions différentes ;
un dispositif de mesure avec au moins deux raccordements pour la mesure d'au moins une propriété électrique ;
un dispositif de lecture de mémoire avec au moins deux raccordements pour la lecture des mémoires de données dans l'adaptateur, lesquels peuvent être raccordés par des connecteurs aux contacts du groupe de raccordement ; et
une matrice de commutation pour la connexion au choix des raccordements du dispositif de mesure et des raccordements du dispositif de lecture de mémoire d'une part aux contacts du groupe de raccordement d'autre part ;
**caractérisé en ce que** l'appareil de test (33) est réalisé pour connecter, par un actionnement de la matrice de commutation (27), les raccordements du dispositif de lecture de mémoire (53) les uns après les autres avec des combinaisons différentes de contacts du groupe de raccordement (33) et, par le dispositif de lecture de mémoire (53), respectivement pour faire effectuer un essai de lecture de mémoire et pour identifier en fonction de ce qui précède pour le deuxième connecteur (45) une position de la pluralité de positions, sur laquelle l'adaptateur (37) est raccordé par l'intermédiaire du deuxième connecteur (45) au groupe de raccordement (33).

10. Appareil de test selon la revendication 9, comprenant en outre un contrôleur d'ordinateur avec une mémoire, dans laquelle l'information concernant au moins une configuration d'un ensemble de lignes à tester est mémorisée.

11. Appareil de test selon la revendication 10, dans lequel le contrôleur d'ordinateur est configuré
pour piloter la matrice de commutation de telle manière que les au moins deux raccordements du dispositif de lecture de mémoire soient connectés tour à tour à différents contacts du groupe de raccordement, et
pour, à chaque pilotage de la matrice de commutation, piloter le dispositif de lecture de mémoire, effectuer l'essai de lecture de mémoire et transmettre au contrôleur d'ordinateur un résultat de l'essai de lecture de mémoire.

12. Appareil de test selon la revendication 11, dans lequel le contrôleur d'ordinateur est configurée en outre pour piloter en fonction des résultats des essais de lecture de mémoire et de l'information concernant la configuration de l'ensemble de lignes à tester la matrice de commutation de manière que les au moins deux raccordements du dispositif de mesure soient connectés tout à tour à différents contacts du groupe de raccordement, et
pour tout pilotage de la matrice de commutation, piloter le dispositif de mesure pour mesurer l'au moins une propriété électrique et pour transférer un résultat de la mesure au contrôleur d'ordinateur.

13. Procédé servant à fabriquer un ensemble de lignes, dans lequel le procédé comprend :
le couplage de connecteurs de l'ensemble de lignes à des premiers connecteurs d'adaptateurs du système de test selon l'une des revendications 1 à 7,
piloter la matrice de commutation du système de test de manière que les au moins deux raccordements du dispositif de mesure du système de test sont connectés tour à tour à différents contacts des connecteurs de l'ensemble de lignes, et
exécuter une mesure par le dispositif de mesure à chaque pilotage de la matrice de commutation.

14. Procédé selon la revendication 13, comprenant en outre une analyse des mesures menées par le dispositif de mesure et la détermination d'une anomalie dans l'ensemble de lignes.

15. Procédé selon la revendication 14, comprenant en outre la suppression de l'anomalie déterminée dans l'ensemble de lignes.
